# EUROPEAN PATENT SPECIFICATION

(11) **EP 0 538 997 B1**
(45) Date of publication and mention of the grant of the patent: **01.07.1998**
(21) Application number: 92307546.9
(22) Date of filing: 18.08.1992
(51) Int. Cl.: G03F 7/031, C08F 2/50, C07D 311/16, C07D 311/18

(54) **Aminoketone sensitizers for aqueous soluble photopolymer compositions**
Aminoketonsensibilisatore für wasserlösliche Photopolymerzusammensetzungen
Sensibilisateur aminocétone pour compositions de photopolymères solubles en milieu aqueux

(30) Priority: 25.10.1991 US 784467; 25.10.1991 US 784468
(43) Date of publication of application: 28.04.1993
(73) Proprietor: MINNESOTA MINING AND MANUFACTURING COMPANY, St. Paul, Minnesota 55133-3427 (US)
(72) Inventor: Ali, Mohammad, Z., c/o Minnesota Mining and, St. Paul, Minnesota 55133-3427 (US)
(74) Representative: Baillie, Iain Cameron

(56) References cited:
- DE-A- 3 822 921
- US-A- 4 971 892
- US-A- 5 055 372

## Description

### BACKGROUND OF THE INVENTION

### Field of the Invention

This invention relates to spectral sensitizers useful in photopolymer applications, for example printing plate and proofing applications. More particularly this invention relates to aminoketone-substituted cournarin sensitizers having tethered tertiary amino groups.

### Background of the Art

Photoinitiators for polymerization reactions ordinarily have an inherent, but limited range of natural radiation sensitivity. Only when the photoinitiators are stimulated by these particular ranges or wavelengths of sensitivity do the photoinitiators display their desired functional ability. It is not feasible and/or economic to attempt to provide different photoinitiators for each different range of wavelengths to which one would desire a polymerizable system to be sensitive. It is therefore better to find ways of changing the wavelength range of sensitivity for a given photoinitiator. Changes in sensitivity can be made by structural alteration of the photoinitiator, but a more accepted and more easily performed method is spectral sensitization of the photoinitiator. This procedure is commonly practiced by finding dyes which absorb radiation in the desired range of wavelengths and which activate the photoinitiator after absorption of the radiation. For each photoinitiator system it is difficult to predict which specific dyes will be able to effectively act as efficient sensitizers. Even though some dyes may work with more than one photoinitiator (or other photosensitive systems such as silver halides, tetrahydracarbyl borates, etc.), there is seldom any certainty that a compound or class of compounds will work with a particular photoinitiator.

Since many spectral sensitizing dyes absorb visible radiation to perform their function, they may be colored and add an undesirable color, tone, or hue to the polymerized material. It is often desirable to provide spectral sensitizing dyes which may be treated to lose their color after they have been used as spectral sensitizers. This can be accomplished in many ways such as thermal bleaching or photobleaching of the dyes.

Sensitizers may also be used which merely increase the speed (sensitivity) of the photoinitiators at those wavelengths to which they are naturally sensitive.

Japanese published applications 63-168403 (Fuji; publication date July 12, 1988) and 63-309502 (Hitachi; publication date July 12, 1988) generically disclose photopolymerizable compositions containing aminoketone and ketocoumarin sensitizing dyes. Neither application describes specific examples which are within the scope of, or demonstrate, the surprising increases in speed associated with the instant invention.

Published EPO application 290,133 (claiming priority to U.S.S.N. 034,065 filed April 2, 1987 and assigned to Minnesota Mining & Mfg. Co.) describes aminostyryl dyes in combination with a sensitizer and an electron donor (which may be a tertiary amine). The published EPO application does not describe the advantages derived from linking the tertiary amine to the sensitizer. Compounds of the instant invention are shown in the examples to have higher sensitivity in photopolymer compositions than those of said published application.

Aromatic aminoketones having carboxyl and amino substituents are disclosed in and U.S. Pat. No. 4,755,450 (Sanders; July 5, 1988). Although some of these are soluble in developers with a pH > 7.5 are not within the scope of the instant invention, and do not teach speed enhancement by incorporation of a water solubilizing substituent.

Benzophenone and thioxanthone photoinitiators having quaternary ammonium substituents have been described in EPO 279,475 (Nicholl et al.; publication date August 24, 1988), EPO 224,967 (Gwane et al., publication date June 10, 1987) and Davies, M.J.; Gwane, G.; Green, P.N.; Green, W.N. *Spec. Publ. -R. Soc. Chem.* **1987**, 64, 184-5. U.S. Pat. No. 4,602,097 (Curtis; July 22, 1986) discloses water soluble photoinitiators with tetraalkylammonium substituents connected through a (poly)ethylene oxide linking group. The above said photoinitiators are not suitable for use with visible wavelength light sources, and are neither aminoketones nor sensitizers.

Specht et al. (U.S. Pat. Nos. 4,147,552; 4,289,844; and 4,278,751; July 14, 1981) disclose aminoketone-substituted coumarins having a variety of substituents including tertiary amino substituents. These patents do not teach the particular advantage of increased photosensitivity of the compounds of the present invention. The aminoketone-substituted coumarin sensitizers materials of Specht et al. do not fall within the formula of the instant invention.

Adair et al. (U.S. Pat. No. 4,713,312; December 15, 1987) discloses the use of aminoketone-substituted coumarins as sensitizers for photosensitive microcapsules. Those material disclosed are essentially similar to those of U.S. Pat. No. 4,147,552.

U.S. Pat. No. 4,289,844 (Specht et al.)and U.S. Pat. No. 4,247,623 (Guild) disclose aminoketone-substituted coumarin sensitizers in combination with amine activators. Neither patent teaches the principal advantage (i.e., speed) which is achieved when a tertiary amine is covalently tethered to an aminoketone-substituted coumarin sensitizer, instead of being added as a secondary component.

### SUMMARY OF THE INVENTION

This invention relates to aqueous-soluble sensitizers for free-radical photopolymerization, and aqueous coatable and aqueous-developable imaging compositions comprising an aqueous-soluble sensitizer, a photoinitiator and a free radically polymerizable monomer.

The invention is achieved by providing aminoketone-substituted coumarin sensitizers, described by the formula: 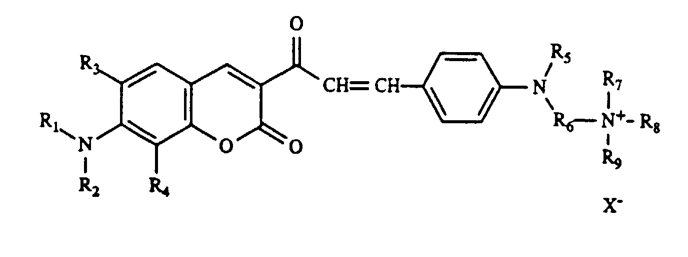 wherein
R₁ and R₂ each represent an alkyl group having 1 to 6 carbon atoms, and
R₃ and R₄ each represent hydrogen; or at least one of R₁ and R₃ or R₂ and R₄ together represent an alkylene group having 2 to 4 carbon atoms;
R₅ represents an alkyl group having 1 to 6 carbon atoms or H;
R₆ represent an alkylene group having 1 to 16 carbon atoms;
R₇, R₈, and R₉ each independently represent an alkyl group having 1 to 6 carbon atoms, or any two of R₇, R₈, and R₉ taken together represent an alkylene group having 4 to 6 carbon atoms; or R₇, R₈, and R₉ taken together with the N atom to which they are bonded represent a quinuclidinio group, or R₆, taken together with R₇, R₈, or R₉ represent a six membered heterocyclic ring group, and X⁻ represents any anion.

In another aspect this invention relates to imageable layers comprising a substrate coated thereon with a free-radically polymerizable compound, a photoinitiator, a spectral sensitizer as described, and optionally a binder.

### DETAILED DESCRIPTION OF THE INVENTION

The term "aminoketone" as used herein means a chemical substance having within its structural formula the substructure: 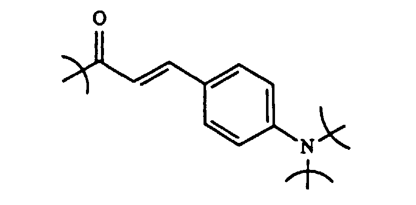 Aminoketone-substituted coumarin sensitizers with tethered tertiary amino groups have extremely good photosensitivity.

The sensitizers of the instant invention are particularly useful when employed in photosensitive compositions. Said photosensitive compositions comprise a solvent soluble free-radical polymerizable monomer or oligomer, a photoinitiator, and optionally a binder.

X⁻ represents any anion. Examples of anions are well known in the imaging art and include, but are not limited to anions with a unitary negative charge such as chloride, bromide, iodide, alkyl and aryl carboxylates, alkyl and aryl sulfonates, bicarbonate, hexafluorophosphate, etc., and anions with a negative charge greater than 1 such as sulfate, phosphate, and the like. Preferably X⁻ represents iodide, chloride, bromide, tetrafluoroborate, hexafluoroantimonate, or hexafluorophosphate. It is of course preferred that the anion not provide any function that might interfere with the properties (e.g. solubility, spectral absorption) of the sensitizer or the polymerization reaction which it is to help initiate.

While not being bound by theory, it is believed to have been determined by the inventor in the discovery of this invention that the tethered tertiary amine functions in essentially the same manner as when a tertiary amine is added separately as an activator, yet provides for superior performance when tethered. It is believed that it may be important for the tertiary amine to be electronically isolated from the π-electron system of the sensitizer. This is accomplished in the instant invention by tethering the tertiary amine to the sensitizer by means of an alkylene group. As shown in the examples below, a synergistic increase in speed results from tethering a tertiary amine to an aminoketone-substituted coumarin sensitizer.

Monomers useful in the instant invention may be mono- , di-, or polyfunctional. Examples of suitable monomers useful in this invention are well known and listed in many patents, e.g., U.S. Pat. Nos. 3,895,949 and 4,037,021 and include, but are not limited to, acrylate, methacrylate, and acrylamide moiety containing monomers (e.g., ethyl methacrylate, pentaerythritol triacrylate, pentaerythritol tetraacrylate, N-ethylacrylamide, tris(2-acryloxyethyl)isocyanurate, tris(2-methylacoloxyethyl)isocyanurate, 2-acetoxyethyl methacrylate, tetrahydrofurfuryl methacrylate, bis[4-(2-acryloxyethyl)phenyl]dimethyl methane, diacetone acrylamide, and acrylamidoethyl methacrylate, etc.) Suitable oligomers include, but are not limited to, acrylate end-capped urethane, acrylate, and polyether oligomers, and carboxyl substituted urethane oligomers such as P-11 (described in U.S. Pat. No. 4,228,232). Suitable reactive polymers are described in U.S. Serial No. 07/658,983. Preferred monomers are acrylate and methacrylate containing monomers oligomers. Carboxyl substituted urethane oligomers are highly preferred.

The aminoketone-substituted coumarin sensitizers of the instant invention may generally be used in combination with a photoinitiator. The photoinitiator may be either a single compound which generates radicals on exposure to radiation or a combination of two or more components. Initiation may be direct or sensitized. Preferred photoinitiators are sensitized or unsensitized halomethyltriazines (described in U.S. Pat. No. 3,775,113) and sensitized diaryliodonium salts (described in U.S. Pat. Nos. 3,729,313, 4,058,400, 4,058,401, and 4,921,827). Suitable sensitizers for the preferred photoinitiators for use in addition to the sensitizers for the present invention are described in the foregoing references.

The preferred diaryliodonium salts useful in practice of the instant invention may be generally described by the formulae given in U.S. Pat. No. 4,460,154, that is 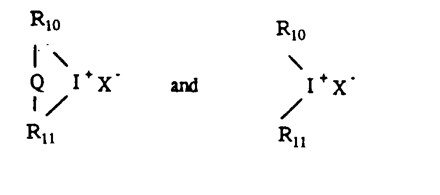 wherein
R₁₀ and R₁₁ are individually selected from aromatic groups. Such aromatic groups may have from 4 to 20 carbon atoms (e.g., substituted or unsubstituted phenyl, naphthyl, thienyl, and furanyl) with substantially any substitution.
Q is selected from a carbon-carbon bond, oxygen, sulfur, 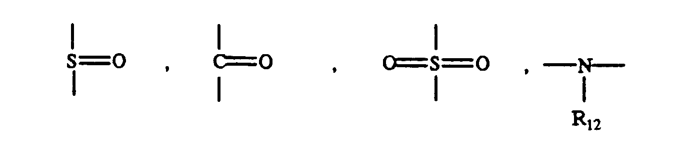 wherein R₁₂ is aryl (e.g., 6 to 20 carbon atoms) or acyl (e.g., 2 to 20 carbon atoms), or R₁₃ C- R₁₄ wherein R₁₃ and R₁₄ are selected from hydrogen, alkyl groups of 1 to 4 carbon atoms, and alkenyl groups of 2 to 4 carbon atoms; and X⁻ is any anion, preferably an anion that does not react with essential components or interfere with the function of other components in the system. Examples of particularly useful anions are well known in the imaging art and include, but are not limited to anions with a unitary negative charge such as chloride, bromide, iodide, alkyl and aryl carboxylates, alkyl and aryl sulfonates (e.g. para-toluene sulfonate), bicarbonate, hexafluorophosphate, etc., and anions with a negative charge greater than 1 such as sulfate, phosphate, and the like. Preferably X⁻ represents iodide, chloride, bromide, tetrafluoroborate, hexafluoroantimonate, or hexafluorophosphate.

Examples of diaryliodonium cations useful in the practice of the instant invention are diphenyliodonium, di(4-chlorophenyl)iodonium, 4-trifluoromethylphenylphenyliodonium, 4-ethylphenylphenyliodonium, di(4-acetylphenyl)iodonium, tolylphenyliodonium, anisylphenyliodonium, 4-butoxyphenylphenyliodonium, di(4-phenylphenyl)iodonium, di(carbomethoxyphenyl)iodonium, etc. Examples of these iodonium cations are disclosed in U.S. Pat. Nos. 3,729,313, 4,076,705, and 4,386,154.

Examples of substituted halomethyltriazines useful in the practice of the instant invention are 2,4-bis(trichloromethyl)-6-methyl-s-triazine, 2,4,6-tris(trichloromethyl)-s-triazine, and styryl substituted triazines such as 2,4-bis(trichloromethyl)-6-(4'-methoxystyryl)-s-triazine, 2,4-bis(trichloromethyl)-6-(*p*-dimethylaminostyryl)-s-triazine, 2,4-bis(trichloromethyl)6-(2',4'-diethoxystyryl)-s-triazine, etc. These compounds are described, for example, in U.S. Pat. Nos. 3,515,552, 3,536,489, 3,617,288, 3,640,718, 3,779,778, 4,386,154, 3,954,475, and 3,987,037.

Photopolymerization of the photosensitive compositions of the instant invention occurs on exposure of the compositions to any source of radiation emitting actinic radiation at a wavelength within the ultraviolet and visible spectral regions. Suitable sources of radiation include, but are not limited to mercury, xenon, carbon arc and tungsten filament lamps, lasers, sunlight, etc. Exposures may be from less than about 1 microsecond to 10 minutes or more depending upon the amounts of particular polymerizable materials, the photoinitiator being utilized and depending upon the radiation source and distance from the source and thickness of the coating to be cured. The photoinitiator is used at a concentration of about 0.01 to 10 percent by weight of the solids content of the coated and dried photosensitive composition.

The photosensitive compositions of the instant invention are normally coated onto a substrate for use in various imaging applications. Substrates may be transparent or opaque. Suitable substrates on which the compositions of the instant invention may be supported include, but are not limited to, metals (for example, steel and aluminum plates including aluminum treated with hydrophilizing agents such as silicates or polyacrylic acid and its derivatives, sheets, and foils); films or plates composed of various film-forming synthetic or high polymers including addition polymers (e.g., poly(vinylidene chloride), poly(vinyl chloride), poly(vinyl acetate), polystyrene, polyisobutylene polymers and copolymers), and linear condensation polymers (e.g., poly(ethylene terephthalate), poly(hexamethylene adipate), poly(hexamethylene adipamide/adipate)). Aluminum is a preferred substrate. Silicated and/or anodized aluminum is particularly preferred.

A binder may optionally be present in photosensitive compositions of the instant invention. Any natural or synthetic aqueous solvent-soluble (or even nonaqueous solvent-soluble in amounts up to about 15 percent by weight) polymeric binder may be used in the practice of this invention. Organic polymeric resins may be used. Thermoplastic resins are generally preferred. Examples of suitable binders are sulfonated polystyrene, polyvinyl alcohol, starch, polymethyl methacrylate, polyvinyl acetate. Beyond these minimal requirements, there is no criticality in the selection of a binder. In fact, even transparency or translucency are not required although they are desirable.

Water-based solvents useful in developing the aqueous developable photopolymerizable compositions of the instant invention are those which have at least 20 weight percent and up to 100 weight percent water. While water-based solvents may be used for both manufacture (i.e., coating of the photopolymerizable composition onto a substrate) and development of the latent image, it is recognized that other solvents with lesser water content may be used in either or both of the aforementioned processes. The water-based solvents useful in the instant invention may include one or more organic solvents, surfactants, stabilizers, or inorganic bases.

The imageable layers of the instant invention may contain various materials in combination with the essential ingredients of the instant invention. For example, plasticizers, coating aids, antioxidants in amounts sufficient to prevent premature cross-linking insufficient to prevent crosslinking of the energy sensitive polymers (e.g., ascorbic acid, hindered phenols, phenidone, etc.), surfactants, antistatic agents, waxes, ultraviolet radiation absorbers, mild oxidizing agents, and brighteners may be used without adversely affecting the practice of the invention.

Where the term group is used in describing substituents, substitution is anticipated on the substituent for example, alkyl group includes ether groups (e.g., CH₃-CH₂-CH₂-O-CH₂-), haloalkyls, nitroalkyls, carboxyalkyls, hydroxyalkyls, sulfoalkyls, etc. while the term alkyl or alkyl moiety includes only hydrocarbons. Substituents which react with active ingredients, such as very strong reducing or oxidizing substituents, would of course be excluded as not being sensitometrically inert or harmless.

### EXAMPLES

In the examples below, the following abbreviations are used: VDM refers to vinyldimethylazlactone; HEMA refers to 2-hydroxymethyl methacrylate; ASATBA refers to mono-tetrabutylammonium aspartate; DMAEMA-C₁₆ refers to 2-dimethylaminoethyl methacrylate quaternized with 1-bromohexadecane as described in copending case U.S.S.N. 07/658,983

All chemicals used below were obtained from Aldrich Chemical Co., Milwaukee, WI) unless otherwise specified. Products were characterized by one or more of the following techniques: ¹H nuclear magnetic resonance . ultraviolet-visible, and infrared spectroscopies; melting point. RE means Reference Example.

### Reference Example 1

1-Methyl-4-methylaminopiperidine (51.2 g), 66 ml dimethyl sulfoxide, 33.0 g 4-fluorobenzaldehyde, and 53.3 g potassium carbonate were combined in a 500 ml three-necked flask fitted with a mechanical stirrer and a condenser. The stirred solution was heated to 90°C for 72 hr. After cooling to room temperature the mixture was poured into 1 liter of water with stirring. The mixture was extracted with 300 ml ethyl acetate. The organic layer was washed with 100 ml water, then dried over anhydrous magnesium sulfate. Upon filtration and evaporation of the ethyl acetate under reduced pressure 35.0 g of *N*-methyl-*N*-(*N*-methylpiperidin-4-yl)-4-aminobenzaldehyde was obtained as a liquid.

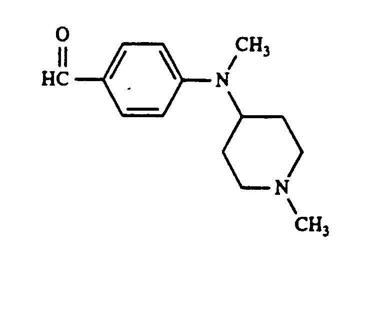

### Reference Example 2

Coumarin 334 (Eastman Kodak, Rochester, NY) 0.28 g, 0.24 g *N*-methyl-*N*-(*N*-methylpiperidin-4-yl)-4-amhobenzaldehyde (prepared above), 0.10 g piperidinium acetate, and 40 ml toluene were combined in a 100 ml round-bottomed flask equipped with a Dean-Stark trap and condenser. The solution was refluxed for 21 hr with removal of water collected in the Dean-Stark trap. The solvent was then removed under reduced pressure and 50 ml water was added. The precipitated solid was filtered, washed with cold ethanol, and dried to give **1** as a red dye; λₘₐₓ (ethanol) = 495 nm.

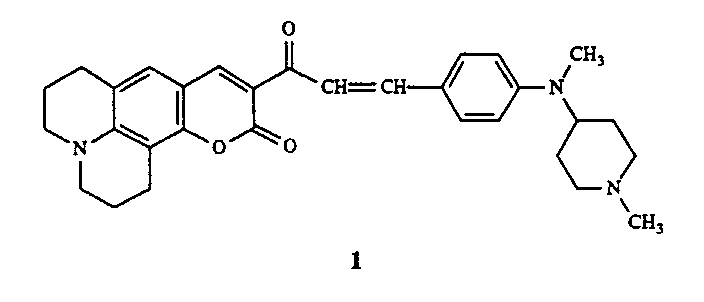

### Reference Example 3

7-Diethylamino-3-acetylcoumarin (1.04 g, prepared according to the procedure described in U.S. Pat. No. 4,147,552), 1.20 g *N*-(2-*N*-piperidinylethyl)-*N*-ethyl-4-aminobenzaldehyde, 0.10 g piperidinium acetate, and 40 ml toluene were placed in a 100 ml round-bottomed flask fitted with a Dean-Stark trap and condenser. The solution was refluxed for 16 hr with removal of collected water. The toluene was evaporated under reduced pressure and a mixture of 20 ml water and 5 ml ethanol was added to the resultant viscous material. Upon stirring a solid precipitated which was isolated by filtration and drying to give 1.5 g of **2** as a red solid; λₘₐₓ (ethanol) = 475 nm.

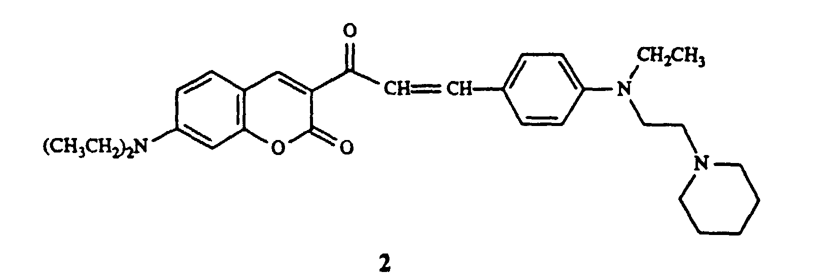

### Reference Example 4

Dye **3** was prepared according to the procedure of ― RE― 3 using 4-(N,N-diethylamino)benzaldehyde in place of the *N*-(2-*N*-piperidinylethyl)-*N*-ethyl-4-aminobenzaldehyde used in ― RE― **3**. Compound 3 had λₘₐₓ (ethanol) = 475 nm.

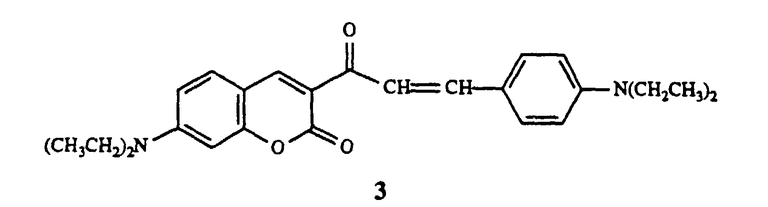

### Reference Example 5

Dye **4** was prepared according to the procedure of ― RE ―3 using *N*-methyl-*N*-(*N*-methylpiperidin-4-yl)-4-aminobenzaldehyde in place of the *N*-(2-*N*-piperidinylethyl)-N-ethyl-4-aminobenzaldehyde used in ― RE ― 3. Compound **4** had λₘₐₓ (ethanol) = 475 nm.

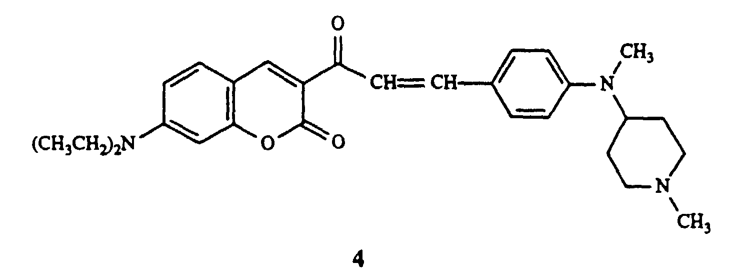

### Reference Example 6

Dye **5** was prepared according to the procedure of ― RE ― 2 using *N*-(2-hydroxyethyl)-*N*'-piperazinylbenzaldehyde (prepared from *N*-(2-hydroxyethyl)piperazine according to ― RE ― 1) in place of *N*-methyl-*N*-(*N*-methylpiperidin-4-yl)-4-amhobenzaldehyde. Compound **5** had λₘₐₓ (ethanol) = 485 nm.

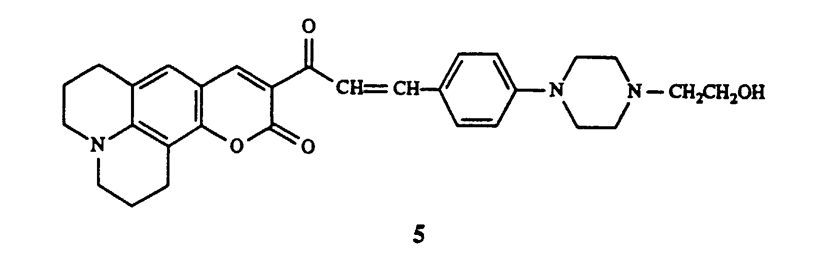

### Reference Example 7

10-(3-(*N*,*N*-Diethylamino-4-arninophenyl)propenoyl)-*1H,2H,3H,5H,6H,7H,11H-*[1]benzopyrano[6,7,8-*ij*]quinolizin-11-one (**6**) was prepared according to the procedure of ― RE ― 2 using *N*,*N*-diethylaminobenzaldehyde in place of *N*-methyl-*N*-(*N*-methylpiperidin-4-yl)-4-aminobenzaldehyde. Compound **6** had λₘₐₓ (ethanol) = 500 nm.

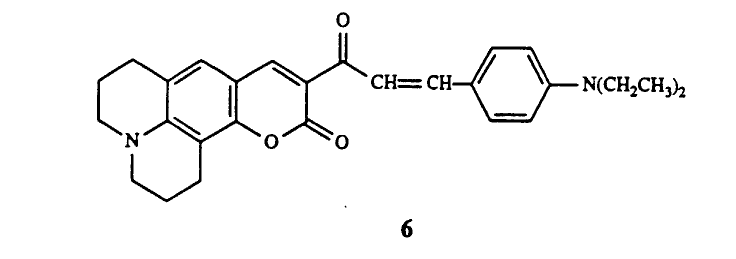

### Reference Example 8

10-(3-(*N*-ethyl-*N*-(2-piperidinoethyl)-4-aminophenyl)propenoyl)-*1H,2H,3H,5H,6H,7H,11H*-[1]benzopyrano[6,7,8-*ij*]quinolizin-11-one (**7**) was prepared according to the procedure of ― RE― 3 wherein 3-acetyl-**7**-diethylaminocoumarin was replaced by Coumarin 334 ; (Eastman Kodak, Rochester, NY) λₘₐₓ (ethanol) = 503 nm

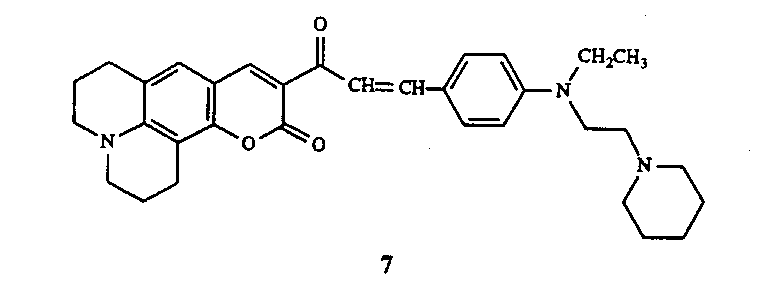

These reference examples demonstrate the use of the above Sensitizers to cure polymerizable monomers.

### Reference Examples 9-14

A solution was prepared from (in parts by weight) 1.8 parts pentaerythritol tetraacrylate (SR-295, Sartomer Co., West Chester, PA), 3.10 parts carboxyl substituted urethane oligomer P-11 (61% in methyl ethyl ketone, described in U.S. Pat. No. 4,228,232), 6.0 parts of a 10% Formvar™ 12/85 (Monsanto Chem. Co., St. Louis, MO) solution in n-propanol/ water (72/28), 60.0 parts *n*-propanol/ water (72/28), 0.07 parts triethylamine (sufficient to solubilize the P-11 in n-propanol/ water (72/28)). To 5.0 part aliquots of this solution were added 0.02 parts diphenyliodonium hexafluorophosphate (described in U.S. Pat. No. 3,729,313 (Smith), April 24, 1973) and 0.006 parts of the sensitizers shown in Table 1. Electrochemically grained, anodized aluminum sheets were coated with the resultant solutions using a #12 wire wound rod (R&D Specialties, Webster, NY) and dried at 70°C for 1 min. The coating weights of the dried plates were approximately 1.61 g m₋₂. The coatings were then overcoated with a 5% by weight solution of poly(vinyl alcohol) (Gelvatol™ 20/30, Monsanto Chem. Co., St. Louis, MO) in water having 0.03% by weight Triton™ X-100 (Rohm and Haas, Philadelphia, PA) as surfactant using a #15 wire wound rod. The overcoated plates were then dried at 70°C for 1 min, placed in a Berkey Ascor model 1415-42 exposure unit with a 5 Kw metal-halide light source, then exposed for 2 sec at the low intensity setting through a √2 21-step sensitivity guide (Stauffer Graphic Arts Co., South Bend, IN). The exposed plates were then developed by wiping with an aqueous developer solution consisting of 3% sodium metasilicate and 4% *n*-propanol. The number of steps (polymer image) remaining after exposure and development are shown in Table 1. The "ghost" values indicate the lowest exposure from which observable photopolymer was retained on the plate. The "solid" values indicate the exposure level at which the photopolymer appeared to completely cover the exposed step.

**Table 1**

| RE | Sensitizer | λₘₐₓ (ethanol) | Steps Solid / Ghost |
|---|---|---|---|
| 9 | **1** | 495 | 16/18 |
| 10 | **5** | 485 | 15/17 |
| 11 | **6** | 500 | 14/16 |
| 12 | **2** | 475 | 15/16 |
| 13 | **4** | 475 | 14/15 |
| 14 | **3** | 475 | 11/13 |

### Example 15-18

A solution was prepared from 1.8 g pentaerythritol tetraacrylate (SR-295, Sartomer Co., West Chester, PA), 3.10 g carboxyl substituted urethane oligomer P-11 (61% in methyl ethyl ketone, described in U.S. Pat. No. 4,228,232), 6.0 g of a 10% Formvar™ 12/85 (Monsanto Chem. Co., St. Louis, MO) solution in *n*-propanol/ water (72/28), 60.0 g *n*-propanol/ water (72/28), 0.07 g triethylamine (sufficient to solubilize the P-11 in *n*-propanol/ water (72/28)). Tri-*n*-propylamine was optionally added as noted in Table 2. To 5.0 part aliquots of this solution were added 0.02 g diphenyliodonium hexafluorophosphate (described in U.S. Pat. No. 3,729,313 (Smith)) and 0.006 g of the sensitizers shown in Table 2. Electrochemically grained, anodized aluminum sheets were coated with the resultant solutions using a #12 wire wound rod (R&D Specialties, Webster, NY) and dried at 70°C for 1 min. The coating weights of the dried plates were approximately 1.61 g m₋₂. The coatings were then overcoated with a 5% by weight solution of poly(vinyl alcohol) (Gelvatol™ 20/30, Monsanto Chem. Co., St. Louis, MO) in water having 0.03% Triton™ X-100 (Rohm and Haas, Philadelphia, PA) as surfactant using a #15 wire wound rod. The overcoated plates were then dried at 70°C for 1 min, placed in a Berkey Ascor model 1415-42 exposure unit with a 5 kW metal-halide light source, then exposed for 2 sec at eitner the low intensity or high intensity setting through a √2 21-step sensitivity guide (Stauffer Graphic Arts Co., South Bend, IN). The exposed plates were then developed by wiping with an aqueous developer solution consisting of 3% sodium metasilicate and 4% *n*-propanol. The number of steps (polymer image) remaining after exposure and development are shown in Table 2. The "ghost" values indicate the lowest exposure from which observable photopolymer was retained on the plate. The "solid" values indicate the exposure level at which the photopolymer appeared to completely cover the exposed step.

**Table 2**

| RE | Sensitizer | Initiator | Tri-*n*-propyl amine | 2 sec Exposure | Steps |
|---|---|---|---|---|---|
| 15 | **3** (6 mg) | 20 mg | 10 mg | low intensity | 12/14 |
| 16 | **3** (6 mg) | 20 mg | none | low intensity | 11/13 |
| 17 | **3** (6 mg) | none | 10 mg | high intensity | 1/3 |
| 18 | **2** (6 mg) | none | none | high intensity | 5/6 |

### Reference Example 19-21

A solution of 0.3 g pentaerythritol tetraacrylate (SR-295, Sartomer Co., 50% in isopropanol/water azeotrope), 1.0 g of a copolymer of VDM (95%) and DMAEMA-C₁₆ (5%) wherein the VDM groups were modified by reaction with HEMA (70%)/ ASATBA (10%)/ water (20%) (i.e., polymer having pendant ethylenic, carboxy, and quaternary ammonium groups) as a 33% solution in methyl ethyl ketone, (described in copending U.S. Ser. No. 07/658,983), and 6.0 g isopropanol water azeotrope. Two 6.0 g aliquots of this solution were each combined with the amount of sensitizer indicated in Table 4 and 40 mg diphenyliodonium hexafluorophosphate. These solutions were coated using a #22 wire wound rod (1.98 mil wet thickness) onto a mechanically grained silicated aluminum sheet (substrate A) and an ammonium bifluoride etched and silicated aluminum sheet (substrate B). Each plate was exposed through a √2 21-step sensitivity guide for two seconds in a 3M Model 70 exposure unit (tungsten iodide lamp, 3M Company, St Paul, MN), then developed by mild rubbing with a cotton pad while submerged in a 0.1 N sodium bicarbonate solution. The results are given in Table 3.

**Table 3**

| RE | Sensitizer | Substrate | Steps | |
|---|---|---|---|---|
| | | | Solid | Ghost |
| 19 | **7** | B | 15 | 16 |
| 20 | **7** | A | 13 | 16 |
| 21 (Control) | **6** | B | 10 | 11 |

### Reference Example 22-24

A solution of 2.0 g pentaerythritol tetraacrylate (SR-295, Sartomer Co., 50% in isopropanol/water azeotrope), 1.4 g carboxyl substituted urethane oligomer P-11 (61% in methyl ethyl ketone, described in U.S. Pat. No. 4,228,232), and 26.6 g isopropanol water azeotrope, 12.3 g Klucell™ M (a hydroxypropyl cellulose; Hercules Corp., Wilmington, DE; 1.5% in isopropanol/water azeotrope), 0.07 g triethylamine, and 2.0 g millbase (Sunfast Blue pigment (Sun Chemical, Fort Lee, NJ)/Formvar™ 12/85 (Monsanto Chemical Co., SL Louis, MO) 2 to 1 ratio as a 15% solids solution in isopropanol/water azeotrope). Aliquots (5.0 g) of this solution were combined with 6 mg of the sensitizer indicated in Table 4 and either 40 mg diphenyliodonium hexafluorophosphate or 20 mg tris(trichloromethyl)-*s*-triazine (TTT). These solutions were coated using a #22 wire wound rod (1.98 mil wet thickness) onto a mechanically grained silicated aluminum sheet. The plates were then dried by blowing hot air, then the coated plates were overcoated with a 5% by weight solution of poly(vinyl alcohol) (Gelvatol™ 20/30, Monsanto Chem. Co., St. Louis, MO) in water having 0.03% Triton™ X-100 (Rohm and Haas, Philadelphia, PA) as surfactant using a #16 wire wound rod. Each plate was exposed for 11 sec using a 1 kW high pressure mercury-xenon light source directed through a monochromator with a 20 nm band pass filter centered at 488 nm through a √2 21-step sensitivity guide, then developed by mild rubbing with a cotton pad while submersed in an aqueous developer solution consisting of 2% sodium metasilicate and 4% benzyl alcohoL Speeds were determined by measuring the lamp output with a radiometer. The results are given in Table 4.

**Table 4**

| RE | Sensitizer | Initiator | Speed | Steps | |
|---|---|---|---|---|---|
| | | | ergs/cm² | Solid | Ghost |
| 22 (Control) | **6** | Ph₂I⁺ PF₆ | 660 | 13 | 16 |
| 23 | **7** | Ph₂I⁺ PF₆ | 230 | 16 | 18 |
| 24 | **7** | TTT | 330 | 15 | 17 |

### Example 25

Dimethyl sulfate (5 drops) was added to a stirred solution of 0.20 g **2** in 5 ml dichloromethane and the solution was heated to about 30°C for 1 hr. The mixture was allowed to cool to room temperature and the precipitated (highly water-soluble) red solid 10-(3-(*N*-methyl-*N*-(*N*,*N*-dimethylpiperidinio-4-yl)4-aminophenyl)propenoyl)-*1H,2H,3H,5H,6H,7H,11H*-[1]benzopyrano[6,7,8-*ij*]quinolizin-11-one methylsulfate (25) was filtered and dried; λₘₐₓ (ethanol) = 492 nm, λₘₐₓ (water) = 500 nm.

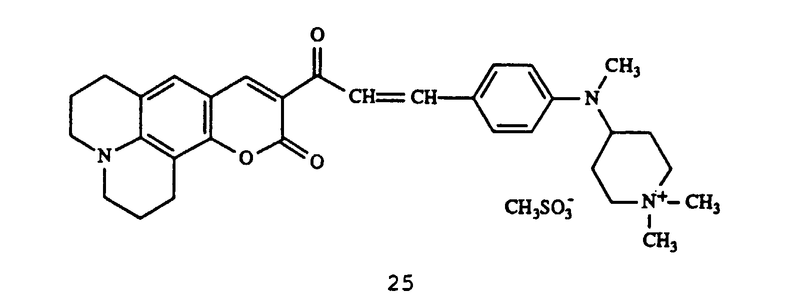

### Reference Examples 26 and 27

Dyes **26** and **27** were prepared according to the procedure of ― RE ― 4 using 4-(diethylamino)benzaldehyde and **1**, respectively, in place of the *N*-(2-piperidinoethyl)-*N*-ethyl-4-aminobenzaldehyde used in ― RE ― 4. The absorption data was: 7-diethylamino-3-(4-diethylaminophenyl)propenoylcoumarin (**26**), λₘₐₓ (ethanol) = 475 nm; 7-diethylamino-3-(*N*-methyl-*N*-(*N*-methylpiperidin-4-yl)-4-aminophenylpropenoyl)coumarin (**27**), λₘₐₓ(ethanol) = 475 nm.

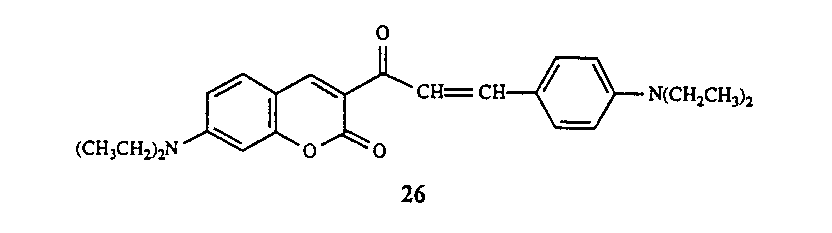

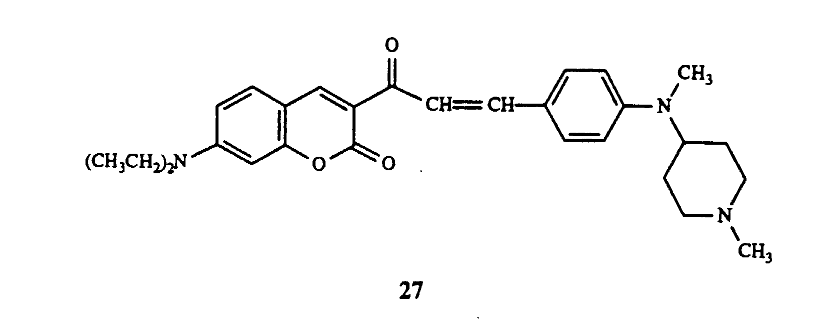

### Example 28

Dimethyl sulfate (5 drops) was added to 0.20 g of **4** in 5 ml toluene. The mixture was heated to about 30°C for 1 hr and allowed to cool to room temperature. The resultant precipitated solid was filtered and dried to give 0.12 g of 7-diethylamino-3-(3-*N*-ethyl-*N*-(2-(*N*-methylpiperidinio)ethyl)-4-aminophenyl)propenoyl)coumarin methylsulfate (28)as a red solid which was highly soluble in water, λₘₐₓ (water) = 485 nm.

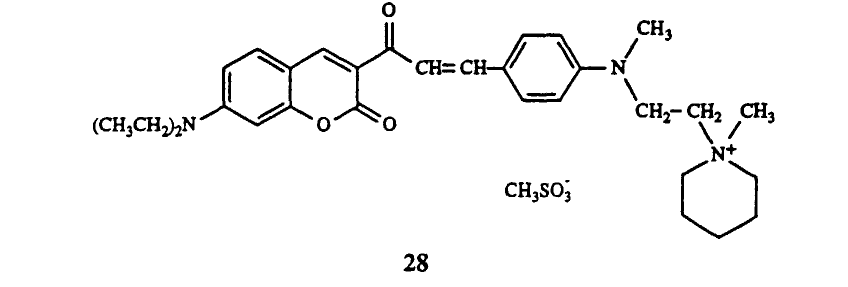

### Example 29

7-Diethylamino-3-(3-(N-methyl-*N*-(*N*,*N*-dimethylpiperidinio-4-yl)-4-aminophenyl)propenoyl)coumarin methylsulfate (**29**) was prepared according to ―RE― 7 except that **27** was used in place of **4**; λₘₐₓ (water) = 473 nm, λₘₐₓ (ethanol) = 468 nm.

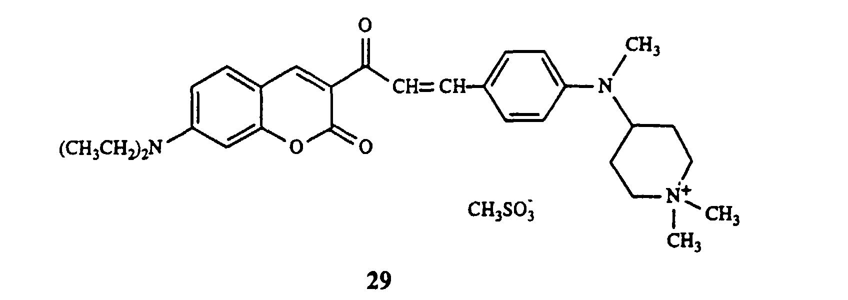

### Reference Example 30

10-(3-(N-ethyl-N-(2-piperidinoethyl)-4-aminophenyl)propenoyl)-*1H,2H,3H,5H,6H,7H,11H*-[1]benzopyrano[6,7,8-*ij*]quinolizin-11-one (**30**) was prepared according to the procedure of RE 3 wherein 3-acetyl-7-diethylaminocoumarin was replaced by Coumarin 334 (Eastman Kodak, Rochester, NY); λₘₐₓ (ethanol) = 503 nm

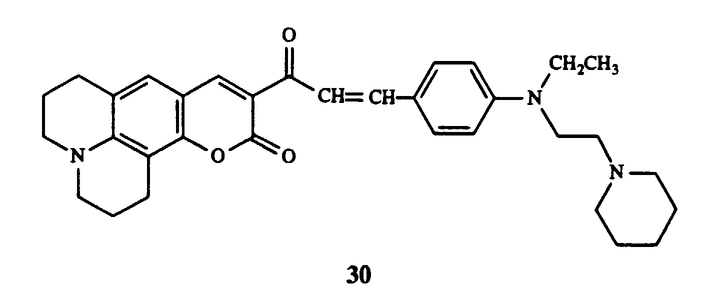

### Example 31

10-(3-(*N*-ethyl-*N*-(2-(*N*-methylpiperidinio)ethyl)-4-aminophenyl)propenoyl)-*1H,2H,3H,5H,6H,7H,11H*[1]benzopyrano[6,7,8-*ij*]quinolizin-11-one (**31**) was prepared according to the procedure of Example 28 wherein **4** was replaced with **30**; λₘₐₓ (water) = 498 nm, λₘₐₓ (ethanol) = 490 nm.

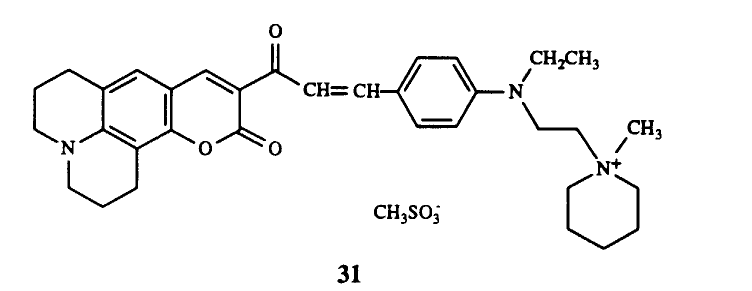

### Example 32-36

A solution was prepared from (in parts by weight) 1.8 parts pentaerythritol tetraacrylate (SR-295, Sartomer Co., Westchester, PA), 3.10 parts carboxyl substituted urethane oligomer P-11 (61% in methyl ethyl ketone, described in U.S. Pat. No. 4,228,232), 6.0 parts of a 10% Formvar™ 12/85 (Monsanto Chem. Co., St. Louis, MO) solution in *n*-propanol/ water (72/28), 60.0 parts n-propanol/ water (72/28), 0.07 parts triethylamine (sufficient to solubilize the P-11 in *n*-propanol/ water (72/28)). To 5.0 part aliquots of this solution were added 0.02 parts diphenyliodonium hexafluorophosphate (described in U.S. Pat. No. 3,729,313 (Smith), April 24, 1973) and 0.006 parts of the sensitizers shown in Table 5. Electrochemically grained, anodized aluminum sheets were coated with the resultant solutions using a #12 wire wound rod (R&D Specialties, Webster, NY) and dried at 70°C for 1 min. The coating weights of the dried plates were approximately 1.61 g m⁻². The coatings were then overcoated with a 5% by weight solution of poly(vinyl alcohol) (Gelvatol™ 20/30, Monsanto Chem. Co., St. Louis, MO) in water having about 0.03% Triton" X-100 (Rohm and Haas, Philadelphia, PA) as surfactant using a #15 wire wound rod. The overcoated plates were then dried at 70°C for 1 min, placed in a Berkey Ascor model 1415-42 exposure unit with a 5 kW metal-halide light source, then exposed for 2 sec at the low intensity setting through a √2 21-step sensitivity guide (Stauffer Graphic Arts Co., South Bend, IN). The exposed plates were then developed by wiping with an aqueous developer solution consisting of 3% sodium metasilicate and 4% *n*-propanol. The number of steps (polymer image) remaining after exposure and development are shown in Table 5. The "ghost" values indicate the lowest exposure from which observable photopolymer was retained on the plate. The "solid" values indicate the exposure level at which the photopolymer appeared to completely cover the exposed step.

**Table 5**

| Example | Sensitizer | λₘₐₓ (ethanol) | Steps Solid / Ghost |
|---|---|---|---|
| 32 | **28** | 470 485 (water) | 12/14 |
| 34 | **29** | 468 483 (water) | 12/14 |
| 36 (comparative) | **26** | 475 | 11/13 |
| 33 | **25** | 492 500 (water) | 16/18 |
| 35 (comparative) | **32** | 500 | 14/16 |

Compound **32** was prepared according to U.S. Pat. No. 4,921,827 and has the formula:

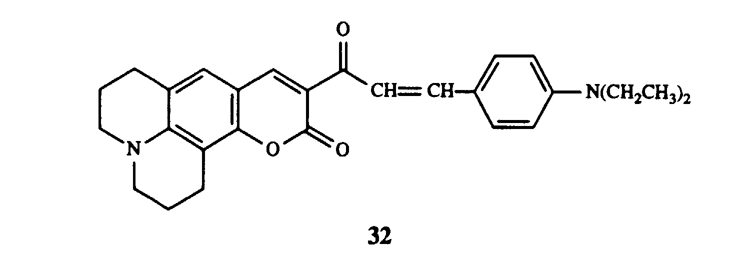

### Example 37

A solution was prepared from 0.2 parts (by weight) 1,3-diacrylamido-2-hydroxypropane (described in U.S. Pat. No. 4,511,646), 1.0 parts of a polymer having pendant ethylenic, carboxy, and quaternary ammonium groups (33% in methyl ethyl ketone, described in copending U.S. Ser. No. 07/658,983, VDM (95%)/ DMAEMA-C₁₆ (5%) wherein the VDM groups were modified by reaction with HEMA(70%)/ ASATBA (10%)/ water (20%)) and 9.0 parts of water / *n*-propanol (9:1). To a 5.0 parts aliquot of this solution was added 0.02 parts of diphenyliodonium chloride and 0.006 parts of **28.** The solution was coated onto an electrochemically grained, anodized, and silicated aluminum substrate using a #12 wire wound rod and dried at 70°C for 2 min. The plate was then top-coated with a 5% aqueous Gelvatol™ 20/30 (a poly(vinyl alcohol) available from Monsanto Chemical Co., St. Louis, MO) solution containing 0.03% Triton™ X-100 (a surfactant available from Rohm and Haas, Philadelphia, PA) and exposed according to ― RE ― 11. The plate was then developed by wiping with a 0.8 percent aqueous solution of sodium bicarbonate. A solid step 7 and ghost step 9 was retained.

### Comparative Example 38

Another 5.0 part aliquot of the coating solution of ― RE ― 17 was combined with 0.02 parts of diphenyliodonium chloride and 0.006 parts of **26**. This non-quaternized sensitizer did not go into solution in the substantially water-based solvent, and after coating and exposure no image formation was observed.

### Example 39-41

A solution of 0.3 g pentaerythritol tetraacrylate (SR-295, Sartomer Co., 50% in isopropanol/water azeotrope), 1.0 g of a copolymer of VDM (95%) and DMAEMA-C₁₆ (5%) wherein the VDM groups were modified by reaction with HEMA (70%)/ ASATBA (10%)/ water (20%) (i.e., polymer having pendant ethylenic, carboxy, and quaternary ammonium groups) as a 33% solution in methyl ethyl ketone, (described in copending U.S. Ser. No. 07/658,983), and 6.0 g n-propanol water azeotrope. Two 6.0 g aliquots of this solution were each combined with 6 mg of sensitizer and 25 mg tris(trichloromethyl)-*s*-triazine. These solutions were coated using a #22 wire wound rod (1.98 mil wet thickness) onto a mechanically grained silicated aluminum sheet (substrate A) and an ammonium bifluoride etched and silicated aluminum sheet (substrate B). Each plate was exposed through a √2 21-step sensitivity guide for two seconds in a 3M Model 70 exposure unit (tungsten iodide lamp, 3M Company, St. Paul, MN), then developed by mild rubbing with a cotton pad while submerged in a 0.1 N sodium bicarbonate solution. The results are given in Table 6.

**Table 6**

| Example | Sensitizer | Substrate | Steps | |
|---|---|---|---|---|
| | | | Solid | Ghost |
| 19 | **31** | A | 14 | 15 |
| 20 | **31** | B | 14 | 15 |
| 21Comparative | **32** | B | 10 | 11 |

## Claims

1. An aminoketone sensitizer for aqueous-developable photopolymer compositions having the formula: 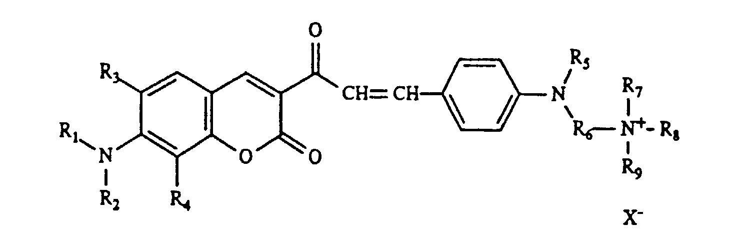 wherein
R₁ and R₂ each represent an alkyl group having 1 to 6 carbon atoms, and
R₃ and R₄ each represent hydrogen; or at least one of R₁ and R₃ or R₂ and R₄ together represent an alkylene group having 2 to 4 carbon atoms;
R₅ represents an alkyl group having 1 to 6 carbon atoms or H;
R₆ represents an alkylene group having 1 to 16 carbon atoms ;
R₇, R₈, and R₉ each independently represent an alkyl group having 1 to 6 carbon atoms, or any two of R₇, R₈, and R₉ taken together represent an alkylene group having 4 to 6 carbon atoms; or R₇, R₈, and R₉ taken together with the N atom to which they are bonded represent a quinuclidinio group, or R₆, taken together with R₇, R₈, or R₉ represent a six membered heterocyclic ring group, and X⁻ represents any anion.

2. The sensitizer of claim 1 wherein R₁ and R₂ independently represent an alkyl group of 1 to 6 carbon atoms.

3. The sensitizer of claims 1 to 2 wherein R₇, R₈ and R₉ independently represent an alkyl group of 1 to 6 carbon atoms.

4. The sensitizer of claims 1 or 2 wherein R₆, R₇, R₈ and R₉ form a N,N-dimethylpiperidinio-4-yl group with the N⁺ atom to which they are attached.

5. A photopolymerizable composition comprising an ethylenically unsaturated free radical polymerizable monomer, a photoinitiator for said monomer, and a sensitizer according to any preceding claim.

## Patentansprüche

1. Aminoketon-Sensibilisator für wässrig entwickelbare Photopolymer-Zusammensetzungen, welcher Sensibilisator die Formel hat: 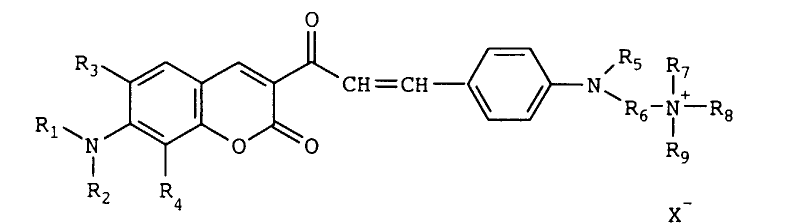 worin sind:
R₁ und R₂ jeweils eine Alkyl-Gruppe mit 1 ... 16 Kohlenstoffatomen
R₃ und R₄ jeweils Wasserstoff, oder mindestens R₁ und R₃ oder R₂ und R₄ sind gemeinsam eine Alkylen-Gruppe mit 2 bis 4 Kohlenstoffatomen;
R₅ eine Alkyl-Gruppe mit 1 bis 6 Kohlenstoffatomen oder H;
R₆ eine Alkylen-Gruppe mit 1 bis 16 Kohlenstoffatomen;
R₇, R₈ und R₉ jeweils unabhängig eine Alkyl-Gruppe mit 1 bis 6 Kohlenstoffatomen oder beliebige zwei von R₇, R₈ und R₉ gemeinsam eine Alkylen-Gruppe mit 4 bis 6 Kohlenstoffatomen;
oder R₇, R₈ und R₉ gemeinsam mit dem N-Atom, an dem sie gebunden sind, eine Chinuclidin-Gruppe; oder R₆ gemeinsam mit R₇, R₈ oder R₉ eine 6-gliedrige heterocyclische Ring-Gruppe, und X- ist ein beliebiges Anion.

2. Sensibilisator nach Anspruch 1, bei welchem R₁ und R₂ unabhängig eine Alkyl-Gruppe mit 1 bis 6 Kohlenstoffatomen darstellen.

3. Sensibilisator nach Anspruch 1 oder 2, bei welchem R₇, R₈ und R₉ unabhängig eine Alkyl-Gruppe mit 1 bis 6 Kohlenstoffatomen darstellen.

4. Sensibilisator nach Anspruch 1 oder 2, bei welchem R₇, R₈ und R₉ mit dem N⁺-Atom, an dem sie sich befinden, eine N,N-Dimethylpiperidino-4-yl-Gruppe bilden.

5. Photopolymerisierbare Zusammensetzung, umfassend ein ethylenisch ungesättigtes, radikalisch polymerisierbares Monomer, einen Photoinitiator für das Monomer und einen Sensibilisator nach einem der vorgenannten Ansprüche.

## Revendications

1. Sensibilisateur du type aminocétone pour des compositions photopolymères développables en milieu aqueux, ayant la formule : 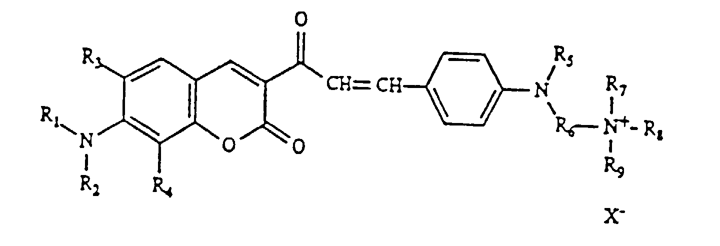 dans laquelle
R₁ et R₂ représentent chacun un groupe alkyle ayant de 1 à 6 atomes de carbone, et R₃ et R₄ représentent chacun un atome d'hydrogène ; ou encore au moins l'un des couples R₁ et R₃, ou R₂ et R₄, représentent ensemble un groupe alkylène ayant de 2 à 4 atomes de carbone ;
R₅ représente un groupe alkyle ayant de 1 à 6 atomes de carbone, ou H ;
R₆ représente un groupe alkylène ayant de 1 à 16 atomes de carbone ;
R₇, R₈ et R₉ représentent chacun indépendamment de l'autre un groupe alkyle ayant de 1 à 6 atomes de carbone, ou encore deux radicaux quelconques choisis parmi R₇, R₈ et R₉ représentent ensemble un groupe alkylène ayant de 4 à 6 atomes de carbone ; ou encore R₇, R₈ et R₉, avec l'atome d'azote auquel ils sont liés, représentent ensemble un groupe quinuclidinio,
ou bien R₆, avec R₇, R₈ ou R₉, représentent un groupe hétérocyclique à six chaînons, et X⁻ représente un anion quelconque.

2. Sensibilisateur selon la revendication 1, dans lequel R₁ et R₂ représentent chacun indépendamment de l'autre un groupe alkyle ayant de 1 à 6 atomes de carbone.

3. Sensibilisateur selon les revendications 1 ou 2, dans lequel R₇, R₈ et R₉ représentent chacun indépendamment des autres un groupe alkyle ayant de 1 à 6 atomes de carbone.

4. Sensibilisateur selon les revendications 1 ou 2, dans lequel R₆, R₇, R₈ et R₉ forment un groupe N,N-diméthylpipéridinio-4-yle avec l'atome N⁺ auquel ils sont liés.

5. Composition photopolymérisable comprenant un monomère à insaturation éthylénique polymérisable par polymérisation radicalaire, un photoamorceur pour ce monomère et un sensibilisateur selon l'une quelconque des revendications précédentes.
